(19) Europäisches Patentamt
European Patent Office
Office européen des brevets

(11) **EP 2 680 317 A1**

(12) **EUROPEAN PATENT APPLICATION**
published in accordance with Art. 153(4) EPC

(43) Date of publication:
**01.01.2014 Bulletin 2014/01**

(21) Application number: **12749546.3**

(22) Date of filing: **22.02.2012**

(51) Int Cl.:
**H01L 31/042** $^{(2006.01)}$

(86) International application number:
**PCT/JP2012/054286**

(87) International publication number:
**WO 2012/115154 (30.08.2012 Gazette 2012/35)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **23.02.2011 JP 2011036661**

(71) Applicant: **Mitsubishi Rayon Co., Ltd. Tokyo 100-8253 (JP)**

(72) Inventors:
• **OOTSUKI, Haruko**
**Yokohama-shi, Kanagawa 230-0053 (JP)**

• **OGASAWARA, Hayato**
**Yokohama-shi, Kanagawa 230-0053 (JP)**
• **KAJISA, Taira**
**Yokohama-shi, Kanagawa 230-0053 (JP)**
• **MIZUHARA,Kazumi**
**Yokohama-shi, Kanagawa 230-0053 (JP)**

(74) Representative: **TBK**
**Bavariaring 4-6**
**80336 München (DE)**

(54) **SOLAR CELL MODULE**

(57) An unwarped, lightweight solar cell module with excellent durability in a thermal cycling test and a humidity freeze test is provided. The solar cell module includes: a solar cell; a sealing member for having the solar cell embedded; a front surface protection member; and a back surface protection member. The back surface protection member includes a plate-like structure (a) including a fibrous reinforcement material with a thickness of 6 mm or less and with a mean linear expansion coefficient of 40 ppm/°C or less at a temperature of 20 to 25°C, and the front surface protection member includes a plate-like structure (b) including a light-transmitting resin material with a thickness of 0.03 mm or more and 0.6 mm or less.

FIG. 1

**Description**

TECHNICAL FIELD

The present invention relates to a solar cell module, and more specifically to a solar cell module which is lightweight and sufficiently durable and which can be manufactured at low cost.

BACKGROUND ART

A conventional solar cell module has a sunlight incident surface provided with a transparent front surface protection member and a back surface provided with a back surface protection substrate colored with white, black, or the like. Furthermore, between these surfaces, a transparent sealing member and a solar cell are disposed. As the transparent front surface protection member disposed on the sunlight incidence surface, in general, tempered glass with excellent mechanical strength and high transmittance of sunlight is employed.

Moreover, in recent years, the use of a transparent resin sheet for the front surface protection member has been considered for weight reduction. For example, in a solar cell module disclosed in Patent Document 1, a glass epoxy substrate or a paper epoxy substrate of 3 to 4 mm in thickness is employed as a back surface protection member and an acrylic resin or a polycarbonate resin as a front surface protection member.

CITATION LIST

PATENT LITERATURE

Patent Document 1: JP2009-266958A

SUMMARY OF INVENTION

TECHNICAL PROBLEM

The front surface protection member made of tempered glass, however, has higher specific gravity than one made of a resin material or the like, thereby increasing the weight of the solar cell module. Thus, any building where the solar cell module is installed may need a reinforcement work. Moreover, a vehicle mounted with the solar cell module having the front surface protection member made on tempered glass may lead to an increase in fuel cost. Moreover, the glass may be broken by vibration or the like of the vehicle might cause the glass to be broken.

The solar cell module configured as disclosed in Patent Document 1 may warp in the process for manufacturing the module. Further, when such a solar cell module is subjected to a thermal cycling test or a humidity freeze test, the solar cell module may cause a trouble as a result of cracking in the solar cell, distortion of a wire member, wire disconnection, or the like.

An object of the present invention is to provide an unwarped, lightweight solar cell module with excellent durability in a thermal cycling test and a humidity freeze test. Another object of the present invention is to provide a solar cell module that can be manufactured at low cost.

SOLUTIONS TO PROBLEM

The objects are achieved by the following aspects [1] to [8] of the present invention.

[1] A solar cell module including a solar cell, a sealing member for having the solar cell embedded, a front surface protection member, and a back surface protection member, in which: the back surface protection member includes a plate-like structure (a) including a fibrous reinforcement material with a thickness of 6 mm or less and with a mean linear expansion coefficient of 40 ppm/°C or less at a temperature of 20 to 25°C; and the front surface protection member includes a plate-like structure (b) including a light-transmitting resin material with a thickness of 0.03 mm or more and 0.6 mm or less.

[2] The solar cell module according to [1], in which the weight per unit area of the back surface protection member is 6 kg/m$^2$ or less.

[3] The solar cell module according to [1] or [2], in which the plate-like structure (a) further includes a binder resin.

[4] The solar cell module according to [1], in which the fibrous reinforcement material is an inorganic substance.

[5] The solar cell module according to [1], in which the fibrous reinforcement material is inorganic glass.

[6] The solar cell module according to [1], in which the plate-like structure (a) is a glass epoxy sheet including glass cloth and an epoxy resin.

[7] The solar cell module according to [1], in which the light-transmitting resin material is an acrylic resin.

[8] The solar cell module according to [1], in which the solar cell is disposed on the front surface protection member side as compared with a neutral plane of the solar cell module.

EFFECTS OF INVENTION

According to the present invention, a solar cell module which is lightweight, is not warped, and has excellent durability in a thermal cycling test and a humidity freeze test can be provided. Further, according the present invention, a solar cell module that can be manufactured at low cost can be provided.

BRIEF DESCRIPTION OF THE DRAWINGS

FIG. 1 is a schematic sectional view of one embodiment of a solar cell module according to the present invention.

FIG. 2 is a schematic view of quadruple solar cells used in the solar cell module according to the present invention.

FIG. 3 is a schematic view of a solar cell module including a single cell, which is used in a steel ball drop test of the present invention.

FIG. 4 is a schematic view illustrating the concept of the neutral plane of the present invention.

FIG. 5 is a schematic sectional view of a solar cell module in which the solar cell is disposed on the front surface protection member side as compared with the neutral plane.

FIG. 6 is a schematic sectional view of a solar cell module in which the solar cell is disposed on the back surface protection member side as compared with the neutral plane.

DESCRIPTION OF EMBODIMENTS

A solar cell module according to the present invention is hereinafter described in detail. The term "(co)polymerization" used herein refers to homopolymerization or copolymerization. In addition, the term "(co)polymer" used herein refers to a homopolymer or a copolymer. Furthermore, the term "(meth)acrylate" used herein refers to acrylate or methacrylate.

[Solar cell module]

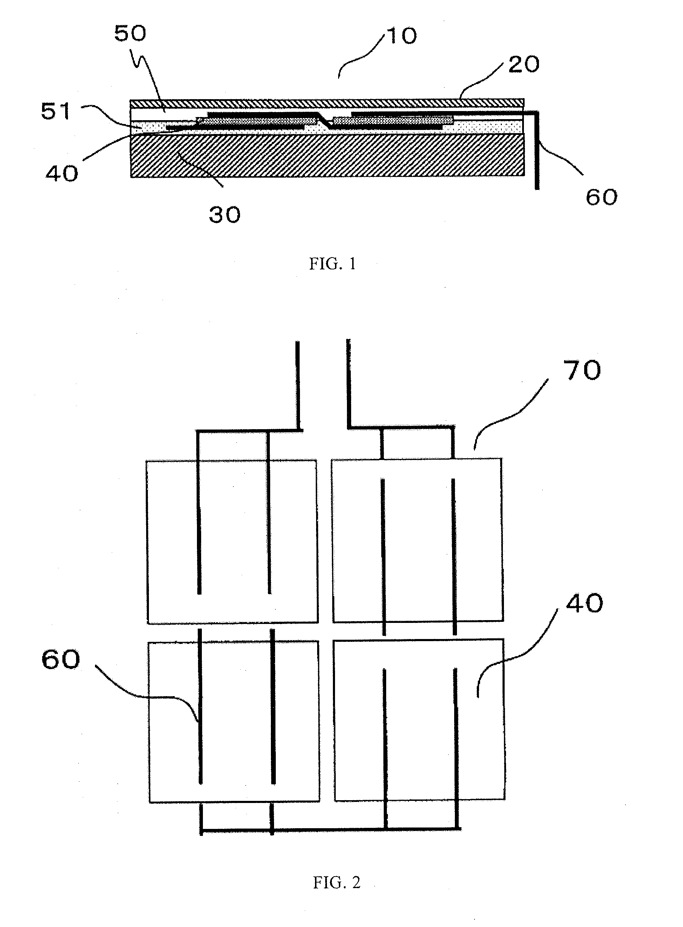

FIG. 1 is a schematic sectional view of a solar cell module according to an embodiment of the present invention. As illustrated in FIG. 1, a solar cell module 10 includes a front surface protection member 20, a back surface protection member 30, a solar cell 40, sealing members 50 and 51, and a wire member 60. Specifically, the front surface protection member 20 is disposed at a light-receiving surface side (front surface side) on which sunlight is incident. The back surface protection member 30 is disposed at the side (back surface side) opposite to the light-receiving surface. Between the front surface protection member 20 and the back surface protection member 30, the sealing member 50, the solar cell 40, and the sealing member 51 are stacked in this order from the light-receiving surface side. The wire member 60 is connectable to the outside of the module.

FIG. 2 schematically illustrates quadruple solar cells 70 as a connection example of the solar cells. In this figure, the wire member 60 connects four solar cells 40 in a two by two array

[Back surface protection member]

In the present invention, the back surface protection member includes a plate-like structure (a) with a thickness of 6 mm or less and a mean linear expansion coefficient of 40 ppm/°C or less at a temperature of 20 to 25°C. This plate-like structure (a) includes a fibrous reinforcement material.

As the back surface protection member, a product including a fibrous reinforcement material can be used. As one embodiment of this product, a composite including a fibrous reinforcement material and a binder resin, a plate-like structure formed by compressing a fibrous reinforcement material, or the like is given.

The form of the fibrous reinforcement material is not particularly limited. The fibrous reinforcement material can be suitably selected from a unidirectional material, cloth, paper (also called nonwoven fabric), wool, mat, short fiber (also called cut fiber, milled fiber, or the like), and so on depending on the intended use.

The kind of the fibrous reinforcement material is not particularly limited. Examples of the fibrous reinforcement material, which can be used, include glass fiber (typified by, for example, E-glass, C-glass, S-glass, NE-glass, and T-glass), carbon fiber, aramid fiber, boron fiber, alumina fiber, and silicon carbide fiber. Any of these may be used alone or in combination of two or more thereof as the fibrous reinforcement material. Alternatively, two or more of them may be used in hybrid. The fibrous reinforcement material is preferably an inorganic substance, and more preferably inorganic glass.

The fibrous reinforcement material may be surface treated with a coupling agent. This can improve the affinity and adhesion between the fibrous reinforcement material and the binder resin. Thus, the back surface protection member can be prevented from decreasing in the transparency and strength due to gap formation. The mean linear expansion coefficient of the plate-like structure (a) of the back surface protection member is in the range of 40 ppm/°C or less. A mean linear expansion coefficient of more than 40 ppm/°C is not preferable. If the mean linear expansion coefficient exceeds 40 ppm/°C, the solar cell module is warped. Moreover, when the thermal cycling test and the humidity freeze test are performed, the solar cell is cracked or the wire member is distorted or disconnected. The mean linear expansion coefficient of the plate-like structure (a) is preferably 35 ppm/°C or less. For easily obtaining the material, the mean linear expansion  coefficient is preferably 1 ppm/°C or more.

The back surface protection member has a thickness of 6 mm or less. Exceeding 6 mm in thickness is not preferred because of difficulty in weight reduction of the solar cell module. The back surface protection member is preferably 0.2 mm or more in thickness from the viewpoint of its function as a protection member (protection function).

The back surface protection member has a weight per unit area of preferably 6 kg/m$^2$ or less, more preferably 5.6 kg/m$^2$ or less, and particularly preferably 5.2 kg/m$^2$ from the viewpoint of reducing the weight of the solar cell module. Here, the term "unit area" herein refers to a unit area in plane of the plate-like structure (a).

The kind of the binder resin included in the back surface protection member is not particularly limited. Examples of the binder resin, which can be used, include a thermosetting resin such as an epoxy resin, a polyamide resin, a phenol resin, or saturated polyester, and a thermoplastic resin such as an acrylic resin.

The back surface protection member can contain a flame-retardant agent, an agent for providing weather resistance, or the like.

Specific examples of the plate-like structure (a) include a glass epoxy sheet including glass cloth and an epoxy resin. Further, a sheet-like material formed by integrating glass fiber and resin fiber through compression or thermofusion can be  used as the plate-like structure (a).

[Front surface protection member]

In the present invention, the front surface protection member includes a plate-like structure (b) with a thickness of 0.03 to 0.6 mm. This plate-like structure (b) contains a light-transmitting resin material.

The kind of the plate-like structure (b) including the light-transmitting resin material that forms the front surface protection member is not particularly limited as long as the plate-like structure (b) has a high total light transmittance. For improving the use efficiency of sunlight, the front surface protection member has a total light transmittance of preferably 85% or more, and more preferably 90% or more.

From the viewpoint of the light-transmitting property, examples of the light-transmitting resin material include an acrylic resin, a fluorine resin, a polycarbonate resin, a polyester resin such as polyethylene terephthalate and polyethylene naphthalate, a styrene resin, a cellulose resin, an acrylonitrile-butadiene-styrene copolymer, an olefin resin, a polyamide resin, a vinyl chloride resin, and a polymethacrylimide resin.

From the viewpoint of the weather resistance, preferably, examples of the light-transmitting resin material include an acrylic resin and a fluorine resin, and specifically include (co)polymers of one of or two or more monomers including a  (meth)acrylate monomer such as methyl(meth)acrylate, ethyl(meth)acrylate, propyl(meth)acrylate, n-butyl (meth)acrylate, i-butyl(meth)acrylate, s-butyl(meth)acrylate, t-butyl(meth)acrylate, 2-ethylhexyl(meth)acrylate, lauryl (meth)acrylate, alkyl(meth)acrylate, tridecyl(meth)acrylate, stearyl(meth)acrylate, cyclohexyl(meth)acrylate, benzyl (meth)acrylate, phenoxyethyl(meth)acrylate, isobornyl(meth)acrylate, glycidyl(meth)acrylate, tetrahydrofurfuryl(meth) acrylate, allyl(meth)acrylate, 2-hydroxyethyl(meth)acrylate, hydroxypropyl(meth)acrylate, 2-methoxyethyl(meth)acrylate, or 2-ethoxyethyl(meth)acrylate; a fluorine-substituted (meth)acrylate monomer such as 2,2,2-trifluoroethyl(meth) acrylate, 1,1,2,2-tetrafluoroethyl(meth)acrylate, or 2,2,3,3,4,4,5,5-octafluoropentyl(meth)acrylate; a fluorocarbon monomer such as vinylidene fluoride; a bifunctional monomer such as ethylene glycol di(meth)acrylate, tripropylene glycol di(meth)acrylate, isocyanuric acid ethylene oxide modified di(meth)acrylate, triethylene glycol di(meth)acrylate, diethylene glycol di(meth)acrylate, neopentyl glycol di(meth)acrylate, 1,6-hexandiol di(meth)acrylate, 1,5-pentane diol di(meth) acrylate, 1,3-butylene glycol di(meth)acrylate, polybutylene glycol di(meth)acrylate, 2,2-bis(4-(meth)acryloxypolyethoxyphenyl)propane, 2,2-bis(4-(meth)acryloxyethoxyphenyl)propane, 2,2-bis(4-(3-(meth)acryloxy-2-hydroxypropoxy)phenyl)propane, 1,2-bis(3-(meth)acryloxy-2-hydroxypropoxy)ethane, 1,4-bis(3-(meth)acryloxy-2-hydroxypropoxy)butane, dimethylol tricyclodecane di(meth)acrylate, bisphenol-A-ethylene oxide adduct di(meth)acrylate, bisphenol-A-propylene oxide adduct di(meth)acrylate, hydroxypivalate neopentyl  glycol di(meth)acrylate, divinylbenzene, or methylene bisacrylamide; a trifunctional monomer such as pentaerythritol tri(meth)acrylate, trimethylol propane tri(meth)acrylate, trimethylol propane ethylene oxide modified tri(meth)acrylate, trimethylol propane propylene oxide modified triacrylate, or isocyanuric acid ethylene oxide modified tri(meth)acrylate; a condensation mixture of succinic acid/trimethylol ethane/acrylic acid; a tetra- or more-functional monomer such as dipentaerythritol hexa(meth)acrylate, dipentaerythritol penta(meth) acrylate, ditrimethylol propane tetraacrylate, or tetramethylol methane tetra(meth)acrylate; bi- or more-functional urethane acrylate; and bi- or more-functional polyester acrylate.

The plate-like structure (b) can contain a fibrous organic substance or an inorganic substance such as glass in the range that does not deteriorate the total light transmittance of the front surface protection member. The form of the fibrous substance is not particularly limited. As the fibrous substance, a unidirectional material, cloth, nonwoven fabric, short fiber (cut fiber, milled fiber), or the like is given. Any of these may be used alone or may be used in combination of two or more of them.

The plate-like structure (b) may have a single-layer structure, or a multilayer structure including two layers or three or more layers. The composition of the resin material of the plate-like structure may be changed gradually in the thickness direction. For example, when the plate-like structure (b) has a multilayer structure in which a fluorine-based resin layer is disposed as a surface layer, the plate-like structure (b) can have the weather resistance and the antifouling property, which are the features of the fluorine resin. As a method for forming the multilayer structure, a known method such as co-extrusion can be used.

The front surface protection member can contain a rubber-based polymer. The rubber-based polymer may be a graft polymer formed by multi-stage polymerization and having a so-called core-shell type multilayer structure. This polymer has one or more inner rubber layers and an outer graft layer. This rubber layer preferably includes a polymer with a glass transition temperature of 25°C or less. The glass transition temperature can be measured based on JIS K7121.

The kind of the rubber composition that forms the rubber layer is not particularly limited. This rubber composition may be, for example, rubber obtained by polymerizing any of the following monomers: an alkyl(meth)acrylate monomer; a silicone monomer; a styrene monomer; a nitrile monomer; a conjugated diene monomer; a monomer generating a urethane bond; an ethylene monomer; a propylene monomer; and an isobutene monomer. The rubber layer may have a cross-linking formed by a cross-linking agent. Further, a chemical bond by a cross-linking agent may be formed between the rubber-based polymer forming the rubber layer and the polymer forming the layer adjacent to this rubber layer. The multilayer structure of the rubber-based polymer may be of three layers or of four or more layers.

Resin that forms the rubber layer is not particularly limited. Examples of the resin include polymers of the following materials: alkyl(meth)acrylate with an alkyl group having a carbon number of 1 to 8, such as methyl(meth) acrylate, butyl(meth)acrylate, 2-ethylhexyl(meth)acrylate, and cyclohexyl(meth)acrylate; styrene; and acrylonitrile.

Examples of the cross-linking agent used for forming the rubber layer include: alkylene glycol dimethacrylate such as ethylene glycol dimethacrylate, 1,3-butylene glycol dimethacrylate, 1,4-butylene glycol dimethacrylate, and propylene glycol dimethacrylate; allyl acrylate; allyl methacrylate; diallyl phthalate; triallyl cyanurate; triallyl isocyanurate; divinyl benzene; diallyl maleate; trimethylol propane triacrylate; and allyl cinnamate. Any of these may be used alone or may be used in combination of two or more of them.

The graft composition grafted in this rubber layer is not particularly limited. Examples of this graft composition include: alkyl(meth)acrylate with an alkyl group having a carbon number of 1 to 8, such as methyl(meth)acrylate, ethyl (meth)acrylate, butyl(meth)acrylate, or 2-ethylhexyl(meth)acrylate; cycloalkyl(meth)acrylate with a cycloalkyl group having a carbon number of 3 to 8, such as cyclohexyl(meth)acrylate; an aromatic vinyl compound such as styrene; and a vinyl cyanide compound such as acrylonitrile. Any of these may be used alone or may be used in combination of two or more of them.

The graft composition grafted in this rubber layer is preferably selected to make the glass transition temperature Tg1 of the graft composition higher than the glass transition temperature Tg2 of the resin composition of the rubber layer. For example, Tg2 is in the range of -50 to 20°C and Tg1 is in the range of 50 to 100°C.

The front surface protection member may contain a light-resistant stabilizer such as an ultraviolet absorbing agent or a light stabilizer. The kind of the ultraviolet absorbing agent is not particularly limited. Examples of the ultraviolet absorbing agent include a salicylic acid compound, a benzophenone compound, and a cyanoacrylate compound. Examples of the light stabilizer include a hindered amine-based light stabilizer such as bis(2,2,6,6-tetramethyl-4-piperidyl) sebacate. Any of these may be used alone or may be used in combination of two or more of them.

The front surface protection member may contain a flame-retardant agent. The kind of the flame-retardant agent is not particularly limited. As necessary, the front surface protection member may contain a plasticizer, an antistatic agent, a mold release agent, a dyeing agent, a pigment, a heat-resistance improving agent, a crystal nucleating agent, a fluidity improving agent, a conductivity imparting agent, a surfactant, a compatibilizer, an antifogging agent, a foaming agent, an antimicrobial agent, a fluorescent agent, or the like.

For allowing the surface of the front surface protection member to have the antifouling property and the scratch resistance and for controlling the adhesion between the front surface protection member and the sealing member, for example, the front surface protection member can be subjected to surface treatment such as plasma process, corona process, or application of a coating material.

The front surface protection member has a thickness of 0.03 to 0.6 mm. When the thickness of the front surface protection member is smaller than 0.03 mm, wrinkles may be caused at the time of lamination. In this case, for example, the sealing member might be exposed due to the scratch caused when the solar cell module is installed. This may cause short-circuiting. Moreover, when a thermal cycling test or a humidity freeze test is performed, the front surface protection member may be cracked. Meanwhile, the front surface protection member having a thickness of more than 0.6 mm is not preferred. When the front surface protection member has a thickness of more than 0.6 mm, the total weight of the solar cell module increases. Moreover, when the thermal cycling test and the humidity freeze test are performed, the solar cell easily cracks and the wire member is easily distorted or disconnected.

[Solar cell]

The solar cell of the present invention is not particularly limited as long as the solar cell can generate power utilizing the photovoltaic effect of semiconductor. Thus, any of conventionally known solar cells can be used as that of the present invention. In particular, from the viewpoint of the balance between the power generation performance and the manufacturing cost, a crystalline silicon cell is preferably used as the solar cell. A crystalline silicon cell, which is easily cracked or broken, can be used as the solar cell of the solar cell module having the structure of the present invention. The wiring pattern of the solar cell may be the one as illustrated in FIG. 2, for example, in which wire members extend across both front and back surfaces of the cell.

[Sealing member]

The sealing member is a member for having the solar cell embedded therein. The shape of the sealing member is not particularly limited. As the sealing member, for example, a sheet-like material, a liquid material, or the like can be used.

The sealing material used for the sealing member is preferably able to seal the solar cell and is preferably the transparent resin having the insulating property. The kind of the sealing material is not particularly limited. Examples of the sealing member include: thermoplastic resin such as ethylene-vinyl acetate copolymer, polyvinyl butyral, ionomer resin, and low-density polyethylene; and curable resin such asurethane resin, epoxy resin, and (meth)acrylate-based resin.

[Neutral plane]

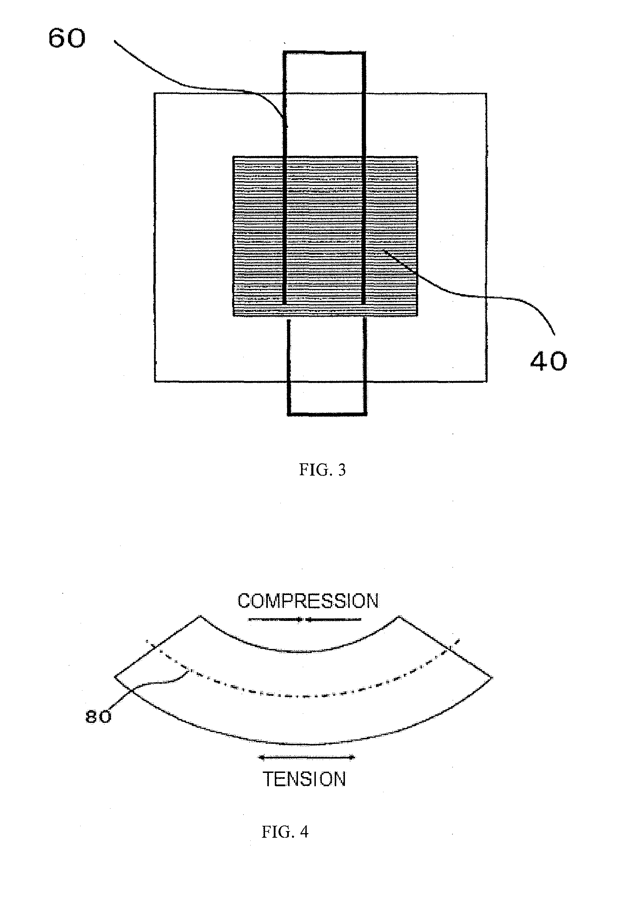

In the solar cell module of the present invention, the solar cell is preferably disposed on the front surface protection member side as compared with a neutral plane of the solar cell module from the viewpoint of the resistance against the impact applied from the front surface protection member side. The term "neutral plane" used herein refers to a plane that is not subjected to tensile stress or compressive stress and does not receive any load when the stress is applied from one surface of the plate-like structure. FIG. 4 schematically illustrates the state in which the stress is applied to the plate-like structure downward in this figure (paper surface). A dash-dot line in the figure represents a neutral plane 80, and the intersecting line between the horizontal sectional plane and the neutral plane corresponds to "neutral axis". Thus, the neutral plane can be obtained by obtaining the neutral axis at each horizontal sectional plane.

According to the composite beam theory of material mechanics, the distance y from the reference line to the neutral axis of the composite beam in which a plurality of materials with different elastic modulus is stacked, such as a multilayer body, is expressed by the following (Formula 1). In other words, when the top side of the composite beam is the reference line, the distance y corresponds to the distance from the top side.

$$y = \Sigma EiBi/\Sigma EiAi \cdots \text{(Formula 1)}$$

where the symbols represent the following:

Ei is the flexural modulus of the member of the i-th layer;
Bi is the statical moment of area of the member of the i-th layer; and
Ai is the area of the cross section of the member of the i-th layer.

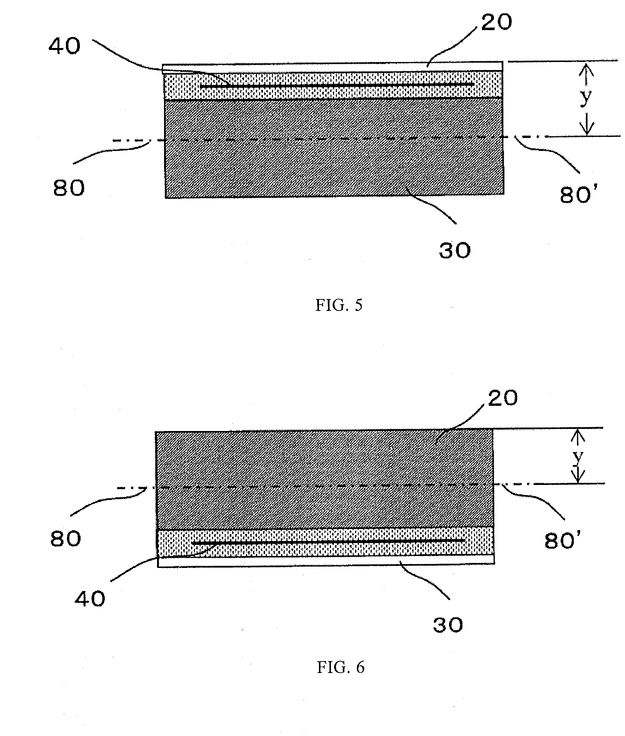

When the stress is applied from a normal direction of the front surface to the solar cell module, which is the multilayer body including the plurality of materials, the neutral plane exists inside the module. FIG. 5 illustrates the state in which the solar cell exists on the front surface protection member side relative to the position of the neutral plane 80 of the solar cell module. When the stress is applied from the front surface protection member side of this module, the solar cell receives the compressive stress. FIG. 6 illustrates the state in which the solar cell exists on the back surface protection member side relative to the position of the neutral plane 80 of the solar cell module. When the stress is applied from the front surface protection member side of this module, the solar cell receives the tensile stress.

EXAMPLES

Hereinafter, the present invention will be described with reference to examples. Prior to the examples, a manufacturing method for the solar cell and various evaluation methods are described. The term "EVA sheet" used herein refers to a sheet of ethylene vinyl acetate copolymer.

[Manufacturing method 1] Solar cell module

The following materials (1) to (5) stacked sequentially are held between two mold release type glass cloth sheets (HONDAFLOH Fabric, manufactured by Honda Sangyo Co., Ltd.) with length and width of 500 mm. This is set on a hot plate of the solar cell module laminator (LM-50X50-S, manufactured by NPC Incorporated.) and crimped in vacuum at a temperature of 135°C for 15 minutes under 10.3 kPa. Consequently, the solar cell module is obtained..
(1) Front surface protection member: a film or sheet with length and width of 400 mm;
(2) sealing member: an EVA sheet with length and width of 400 mm and thickness of 450 $\mu$m (fast cure type, manufactured by SANVIC INC.);
(3) quadruple solar cells which are obtained by serially wiring 2 x 2 cells (polycrystalline cells of 6-inch size, manufactured by Q cells, see FIG. 2);
(4) sealing member: an EVA sheet with length and width of 400 mm and thickness of 450 $\mu$m (fast cure type, manufactured by SANVIC INC.); and
(5) back surface protection member: a film or sheet with length and width of 400 mm.

[Manufacturing method 2] Solar cell module for steel ball drop test

The following materials (1) to (5) stacked sequentially are held between two mold release type glass cloth sheets (HONDAFLOH Fabric, manufactured by Honda Sangyo Co., Ltd.) with length and width of 500 mm. This is set on a hot plate of the solar cell module laminator (LM-50X50-S, manufactured by NPC Incorporated.) and crimped in vacuum at a temperature of 135°C for 15 minutes under 10.3 kPa. Consequently, the solar cell module is obtained.
(1) Front surface protection member: a film or sheet with length and width of 300 mm;
(2) sealing member: an EVA sheet with length and width of 300 mm and thickness of 0.45 mm (CIKcap fast cure type, manufactured by C. I. KASEI CO., LTD.);
(3) one wired solar cell (polycrystalline cell of 6-inch size with a thickness of 0.2 mm, manufactured by Gintech, see FIG. 3);
(4) sealing member: an EVA sheet with length and width of 300 mm and thickness of 0.45 mm (CIKcap fast cure type, manufactured by C. I. KASEI CO., LTD.); and
(5) back surface protection member: a film or sheet with length and width of 300 mm.

[Evaluation 1] Measurement of mean linear expansion coefficient

The mean linear expansion coefficient of the front surface protection member and the back surface protection member is measured by using a thermomechanical analyzer Thermo Plus TMA 8310 (manufactured by Rigaku Corporation). The vertical and horizontal expansion of a measurement sample with a length of 15 mm and a width of 5 mm at a temperature of 20 to 25 °C is measured with a temperature rising rate of 5 °C/min. A quartz reference sample is used as a reference sample to correct the amount of expansion of the holder. The vertical and horizontal linear expansion coefficients are calculated using (Formula 2) below, and the mean value thereof is used as the mean linear expansion coefficient.
$$\text{Linear expansion coefficient} = (1/L_{t1}) \times (L_{t2} - L_{t1}) / (t2 - t1) \cdots \text{(Formula 2)}$$

where $L_{t1}$ is the length (mm) of the sample at 20°C, $L_{t2}$ is the length (mm) of the sample at 25°C, t2 is 25 (°C), and t1 is 20 (°C).

[Evaluation 2] Evaluation on appearance

The solar cell module manufactured according to the procedure of the [Manufacturing method 1] is cooled to the room temperature. Subsequently, the solar cell module is disposed on a flat stage so that the central part of the solar cell module is in contact with the stage and four corners of the solar cell module float from the stage. If the solar cell module is warped, the vertical distance between the four corners of the solar cell module and the stage surface is measured using a scale and its mean value is displayed. When the mean value of this vertical distance is 5 mm or less, the solar cell module is determined as a good product free of warpage. When the mean value of the vertical distance is more than 5 mm, the solar cell  module is determined as a defective product with warpage. Moreover, the presence or absence of the crack of the solar cell is visually checked. The solar cell module with excellent appearance and free of warpage is defined as "rank A". The other solar cell modules are defined as "rank B".

[Evaluation 3] Thermal cycling test and humidity freeze test

After the evaluation on the appearance, the thermal cycling test (TC50) is performed on the solar cell module under the condition prescribed in JIS C8990. Next, the humidity freeze test (HF10) is performed. The specific procedure is as follows: (1) measuring the maximum power value (measurement value V1); (2) conducting the thermal cycling test (TC50); (3) measuring the maximum power value (measurement value V2) and evaluating the appearance; (4) conducting the humidity freeze test (HF10); and (5) measuring the maximum power value (measurement value V3) and evaluating the appearance.

The maximum power value is measured using the solar simulator SPI-SUN SIMULATOR 1116N (manufactured by SPIRE) under the condition in which the temperature is 25°C and the intensity is 1000 W/m$^2$. The solar cell module whose difference in maximum power value before and after each test is 5% or less and which does not change in appearance based on JIS C8990 is regarded as having passed the test, and is defined as "rank A". The solar cell module whose difference in maximum power value before and after each test is more than 5%, and which does not conduct electricity due to disconnection or the like, or which has changed in appearance is regarded as not having passed the test, and is defined as "rank B".

[Evaluation 4] Evaluation of shock resistance

The solar cell module manufactured according to the procedure of the [Manufacturing method 2] is subjected to the steel ball drop test based on JIS 8917 (1998) and JIS R3212 (1998). On this occasion, the maximum power values (measurement values V4 and V5) of the solar cell module before and after the steel ball drop test are measured. The maximum power values are measured using the solar simulator (manufactured by NPC Incorporated.) under the condition in which the temperature is 25°C and the intensity is 1000 W/m$^2$. The solar cell module whose difference in maximum power value before and after the steel ball drop test is 5% or less is regarded as having passed the test. The solar cell module whose difference in maximum power value before and after the steel ball drop test is more than 5%, which does not conduct electricity due to disconnection or the like, is regarded as not having passed the test.

(Example 1)

A solar cell module of Example 1 was manufactured according to the procedure of the [Manufacturing method 1]. An acrylic film 1 (HBS010P with a thickness of 0.10 mm, manufactured by Mitsubishi Rayon Co., Ltd.) was used as the front surface protection member. A glass epoxy sheet (KEL-GEF with a thickness of 1.6 mm, manufactured by Shin-Kobe Electric Machinery Co., Ltd.) was used as the back surface protection member. As a result, a module with excellent appearance and free of warpage was obtained. This module was subjected to the thermal cycling test and the humidity freeze test of the [Evaluation 3]. As a result, there were no change in appearance and no change in maximum power value before and after the test. The results of evaluation are listed in Table 1.

The solar cell module for the steel ball drop test was manufactured using the similar front surface protection member and back surface protection member according to the procedure of the [Manufacturing method 2]. The neutral axis of the solar cell module was obtained using (Formula 1). The result indicated that the solar cell was on the front surface protection member side as compared with the neutral plane 80. This module was subjected to the steel ball drop test of the [Evaluation 4]. As a result, the change in maximum power value before and after the test was 2.9%. Therefore, the module passed the test.

(Example 2)

A solar cell module of Example 2 was manufactured according the procedure of the [Manufacturing method 1]. An acrylic film 2 (HBS006 with a thickness of 0.125 mm, manufactured by Mitsubishi Rayon Co., Ltd.) was used as the front surface protection member. A glass epoxy sheet (KEL-GEF with a thickness of 1.6 mm, manufactured by Shin-Kobe Electric Machinery Co., Ltd.) was used as the back surface protection member. As a result, a module with excellent appearance and free of warpage was obtained. This module was subjected to the thermal cycling test and the humidity freeze test. As a result, there were no change in appearance and no change in maximum power value.

Moreover, the solar cell module for the steel ball drop test was manufactured according to the procedure of the [Manufacturing method 2] using the similar front surface protection member and back surface protection member. The neutral axis of the solar cell module was obtained using (Formula 1). The result indicated that the solar cell was on the front surface protection member side as compared with the neutral plane 80. This module was subjected to the steel ball drop test. As a result, the change in maximum power value before and after the test was 2.2%. Therefore, the module passed the test.

(Example 3)

A solar cell module of Example 3 was manufactured according the procedure of the [Manufacturing method 1]. The acrylic film 2 (HBS006 with a thickness of 0.125 mm, manufactured by Mitsubishi Rayon Co., Ltd.) was used as the front surface protection member. A glass epoxy sheet (KEL-GEF with a thickness of 3.0 mm, manufactured by Shin-Kobe Electric Machinery Co., Ltd.) was used as the back surface protection member. As a result, a module with excellent appearance and free of warpage was obtained. This module was subjected to the thermal cycling test and the humidity freeze test. As a result, there were no change in appearance and no change in maximum power value.

(Example 4)

A solar cell module of Example 4 was manufactured according the procedure of the [Manufacturing method 1]. The acrylic film 2 (HBS006 with a thickness of 0.125 mm, manufactured by Mitsubishi Rayon Co., Ltd.) was used as the front surface protection member. A composite base material including glass long fiber and thermoplastic (polypropylene) fiber (SymaLITE with a thickness of 5.8 mm, manufactured by Quadrant) was used as the back surface protection member. As a result, a module with excellent appearance and free of warpage was obtained. This module was subjected to the thermal cycling test and the humidity freeze test. As a result, there were no change in appearance and no change in maximum power value.

The solar cell module for the steel ball drop test was manufactured according to the procedure of the [Manufacturing method 2] using the similar front surface protection member and back surface protection member. The neutral axis of the solar cell module was obtained using (Formula 1). The result indicated that the solar cell is on the front surface protection member side as compared with the neutral plane 80. This module was subjected to the steel ball drop test. As a result, the change in maximum power value before and after the test was 1.0%. Therefore, the module passed the test.

(Example 5)

The following are mixed and then uniformly dissolved: 39 pts. mass of benzyl methacrylate (Mitsubishi Rayon Co., Ltd.); 51 pts. mass of methyl methacrylate (Mitsubishi Rayon Co., Ltd.); 10 pts. mass of opentyl glycol dimethacrylate (Shin-Nakamura Chemical Co., Ltd.); 0.3 pts. mass of 1-hydroxy-cyclohexyl-phenylketone (Ciba Specialty Chemicals, IRGACURE 184) as a photo polymerization initiator; and 0.05 pts. mass of sodium dioctyl sulfosuccinate (aerosol 0T-100, manufactured by Mitsui Cyanamid) as a mold release agent. Further, degassing was performed under reduced pressure, thereby eliminating the dissolved oxygen and air bubbles out of the system. Thus, a photo-curing liquid 1 was obtained. The cured product obtained by curing this curing liquid 1 had a refractive index of 1.52.

A stack of two glass cloths of C glass with a thickness of 220 $\mu$m and a refractive index of 1.52 (YCM2206N11, manufactured by MOLYMER SSP Co., Ltd.) was impregnated with the photo-curing liquid 1 and the degassing under reduced pressure was further performed. Then, the impregnated glass clothes were removed and put between two PET films (Teijin Tetoron film with a thickness of 0.038 mm, manufactured by Teijin DuPont Films) and cured with UV light at 3000 mJ/cm$^2$. Subsequently, this was heated in an oven at 130°C for 30 minutes. As a result, a glass fiber composite sheet 1 with a thickness of 0.6 mm (total light transmittance of 90% or more) was obtained.

Next, a solar cell module of Example 5 was manufactured according to the procedure of [Manufacturing method 1]. This glass fiber composite sheet 1 was used as the front surface protection member. A glass epoxy sheet (KEL-GEF with a thickness of 1.6 mm, manufactured by Shin-Kobe Electric Machinery Co., Ltd.) was used as the back surface protection member. As a result, a module with excellent appearance and free of warpage was obtained. This module was subjected to the thermal cycling test and the humidity freeze test. As a result, there were no change in appearance and no change in maximum power value.

(Comparative example 1)

In this comparative example, the thickness of the front surface protection member is more than 0.6 mm, and the back surface protection member does not contain the fibrous reinforcement material.
A solar cell module was manufactured according to the procedure of the [Manufacturing method 1]. An acrylic sheet (MR200 with a thickness of 1.5 mm, manufactured by Mitsubishi Rayon Co., Ltd.) was used as each of the front surface protection member and the back surface protection member. As a result, a module with excellent appearance and free of warpage was obtained. This module was subjected to the thermal cycling test. As a result, the solar cell was cracked. Moreover, the wire member was broken. The maximum power value was unable to be measured.

(Comparative example 2)

In this comparative example, the back surface protection member does not contain the fibrous reinforcement material.
The solar cell module of Comparative example 2 was manufactured according to the procedure of the [Manufacturing method 1]. The acrylic film 2 (HBS006 with a thickness of 0.125 mm, manufactured by Mitsubishi Rayon Co., Ltd.) was used as the front surface protection member. As the back surface protection member, a multilayer plametal plate including aluminum and resin with a total thickness of 4.0 mm (a three-layer structure of an aluminum layer with a thickness of 0.5 mm/a resin layer with a thickness of 3.0 mm/and an aluminum layer with a thickness of 0.5 mm, manufactured by SEKISUI JUSHI PLAMETAL CO., LTD.) was used. As a result, a module with excellent appearance and free of warpage was obtained. This module was subjected to the thermal cycling test. As a result, the change in maximum power value was small. However, wrinkles are observed in the aluminum layer. Next, the humidity freeze test was performed. As a result, the wire member was broken and the maximum power value was unable to be measured.

[Table 1]

| | Back surface protection member | | | | Front surface prtection member | | | [Evaluation 3] Appearance prior to test | [Evaluation 3] | |
| --- | --- | --- | --- | --- | --- | --- | --- | --- | --- | --- |
| | Plate-like structure (a) | Mean linear expansion coefficient (ppm/°C) | Thickness (mm) | Weight per unit area (kg/m2) | Plate-like structure (b) | Mean linear expansion coefficient (ppm/°C) | Thickness (mm) | | TC50 | HF10 |
| Example 1 | Glass epoxy sheet | 14 | 1.6 | 2.8 | Acrylic film 1 | 120 | 0.10 | A | A | A |
| Example 2 | Glass epoxy sheet | 14 | 1.6 | 2.8 | Acrylic film 2 | 190 | 0.125 | A | A | A |
| Example 3 | Glass epoxy sheet | 14 | 3.0 | 5.3 | Acrylic film 2 | 190 | 0.125 | A | A | A |
| Example 4 | Composite of polypropylene fiber/glass fiber | 25 | 5.8 | 2.2 | Acrylic film 2 | 190 | 0.125 | A | A | A |
| Example 5 | Glass epoxy sheet | 14 | 1.6 | 2.8 | Glass fiber composite sheet 1 | 15 | 0.6 | A | A | A |
| Comparative example 1 | Acrylic sheet | 66 | 1.5 | 1.8 | Acrylic sheet | 66 | 1.5 | A | B Cell cracked | Not conducted |
| Comparative example 2 | Multilayer plate of aluminum/ resin | 30 | 4.0 | 5.5 | Acrylic film 2 | 190 | 0.125 | A | B Appearance changed | Not conducted |

EP 2 680 317 A1

INDUSTRIAL APPLICABILITY

The solar cell module according to the present invention is of lightweight and free of warpage, and has excellent durability in a thermal cycling test and a humidity freeze test. Further, according the present invention, the solar cell module can be manufactured at low cost. Thus, the solar cell module of the present invention can be suitably used as one for any of house buildings, vehicles, small appliances, and the like.

REFERENCE SIGNS LIST

| | |
|---|---|
| 10 | SOLAR CELL MODULE |
| 20 | FRONT SURFACE PROTECTION MEMBER |
| 30 | BACK SURFACE PROTECTION MEMBER |
| 40 | SOLAR CELL |
| 50 | SEALING MEMBER 1 |
| 51 | SEALING MEMBER 2 |
| 60 | ELECTRODE MEMBER |
| 70 | QUADRUPLE SOLAR CELL |
| 80 | NEUTRAL PLANE |
| 80' | NEUTRAL AXIS |

**Claims**

1. A solar cell module, comprising:

   a solar cell;
   a sealing member for having the solar cell embedded;
   a front surface protection member; and
   a back surface protection member,
   wherein the back surface protection member includes a plate-like structure (a) including a fibrous reinforcement material with a thickness of 6 mm or less and with a mean linear expansion coefficient of 40 ppm/°C or less at a temperature of 20 to 25°C, and the front surface protection member includes a plate-like structure (b) including a light-transmitting resin material with a thickness of 0.03 mm or more and 0.6 mm or less.

2. The solar cell module according to claim 1, wherein the weight per unit area of the back surface protection member is 6 kg/m$^2$ or less.

3. The solar cell module according to claim 1 or 2, wherein the plate-like structure (a) further includes a binder resin.

4. The solar cell module according to claim 1, wherein the fibrous reinforcement material is an inorganic substance.

5. The solar cell module according to claim 1, wherein the fibrous reinforcement material is inorganic glass.

6. The solar cell module according to claim 1, wherein the plate-like structure (a) is a glass epoxy sheet including glass cloth and an epoxy resin.

7. The solar cell module according to claim 1, wherein the light-transmitting resin material is an acrylic resin.

8. The solar cell module according to claim 1, wherein the solar cell is disposed on the front surface protection member side as compared with a neutral plane of the solar cell module.

FIG. 1

FIG. 2

FIG. 3

FIG. 4

FIG. 5

FIG. 6

<table>
<tr><td colspan="2" align="center">**INTERNATIONAL SEARCH REPORT**</td><td>International application No.<br>PCT/JP2012/054286</td></tr>
</table>

| A. CLASSIFICATION OF SUBJECT MATTER |
|---|
| *H01L31/042*(2006.01)i |
| According to International Patent Classification (IPC) or to both national classification and IPC |

| B. FIELDS SEARCHED |
|---|
| Minimum documentation searched (classification system followed by classification symbols)<br>H01L31/04-31/078 |
| Documentation searched other than minimum documentation to the extent that such documents are included in the fields searched<br>Jitsuyo Shinan Koho          1922-1996    Jitsuyo Shinan Toroku Koho    1996-2012<br>Kokai Jitsuyo Shinan Koho    1971-2012    Toroku Jitsuyo Shinan Koho    1994-2012 |
| Electronic data base consulted during the international search (name of data base and, where practicable, search terms used) |

| C. DOCUMENTS CONSIDERED TO BE RELEVANT |

| Category* | Citation of document, with indication, where appropriate, of the relevant passages | Relevant to claim No. |
|---|---|---|
| Y | JP 2009-266958 A  (Sharp Corp.),<br>12 November 2009 (12.11.2009),<br>paragraphs [0025] to [0027], [0046]; fig. 1<br>(Family: none) | 1-8 |
| A | JP 2000-185967 A  (Sumitomo Metal Mining Co.,<br>Ltd.),<br>04 July 2000 (04.07.2000),<br>paragraph [0007]<br>(Family: none) | 1 |
| Y | JP 2010-153502 A  (Toyota Motor Corp.),<br>08 July 2010 (08.07.2010),<br>paragraphs [0015] to [0017]<br>(Family: none) | 1-8 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>08 March, 2012 (08.03.12) | Date of mailing of the international search report<br>19 March, 2012 (19.03.12) |
|---|---|
| Name and mailing address of the ISA/<br>Japanese Patent Office | Authorized officer |
| Facsimile No. | Telephone No. |

Form PCT/ISA/210 (second sheet) (July 2009)

16

**INTERNATIONAL SEARCH REPORT**

International application No.

PCT/JP2012/054286

| C (Continuation). DOCUMENTS CONSIDERED TO BE RELEVANT | | |
|---|---|---|
| Category* | Citation of document, with indication, where appropriate, of the relevant passages | Relevant to claim No. |
| Y | JP 08-139347 A (Canon Inc.),<br>31 May 1996 (31.05.1996),<br>paragraphs [0016], [0042]; fig. 1<br>(Family: none) | 1-8 |
| A | JP 2003-204073 A (Bridgestone Corp.),<br>18 July 2003 (18.07.2003),<br>paragraphs [0027], [0046]; fig. 1<br>(Family: none) | 1-8 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009266958 A